Europäisches Patentamt

European Patent Office

Office européen des brevets

(11) Veröffentlichungsnummer: **0 293 641**
**B1**

(12) **EUROPÄISCHE PATENTSCHRIFT**

(45) Veröffentlichungstag der Patentschrift:
27.12.90

(21) Anmeldenummer: 88107441.3

(22) Anmeldetag: 09.05.88

(51) Int. Cl.⁵: **H01L 21/331,** H01L 29/73

(54) Verfahren zur Herstellung eines voll selbstjustierten Bipolartransistors.

(30) Priorität: **21.05.87 DE 3717153**

(43) Veröffentlichungstag der Anmeldung:
**07.12.88 Patentblatt 88/49**

(45) Bekanntmachung des Hinweises auf die Patenterteilung:
**27.12.90 Patentblatt 90/52**

(84) Benannte Vertragsstaaten:
**AT DE FR GB IT**

(56) Entgegenhaltungen:
**EP-A- 0 029 900**
**EP-A- 0 036 499**
**EP-A- 0 039 411**
**US-H- 104 803**

(73) Patentinhaber: **Siemens Aktiengesellschaft,
Wittelsbacherplatz 2, D-8000 München 2(DE)**

(72) Erfinder: **Schaber, Hans-Christian, Dipl.-Phys.-Dr.,
Ruffiniallee 26, D-8032 Gräfelfing(DE)**
Erfinder: **Meul, Hans-Willi, Dipl.-Phys.-Dr.,
Watzmannstrasse 10a, D-8019 Steinhöring(DE)**

## Beschreibung

Die Erfindung betrifft ein Verfahren zur Herstellung eines voll selbstjustierten, in einer Halbleiterschaltung auf einem Siliziumsubstrat integrierten Bipolartransistors vom npn-Typ mit in vertikaler Richtung im Substrat angeordneten Emitter-, Basis- und Kollektorzonen, bei dem der vergrabene Kollektor durch einen tiefreichenden Anschluß und die aktive Basiszone über eine inaktive Basiszone aus dotiertem polykristallinem Silizium angeschlossen ist und bei dem zur Trennung der Emitter-Basiszone von der Kollektoranschlußzone sowie zur Isolierung des Transistors von benachbarten Bauelementen vergrabene Siliziumoxidbereiche im Substrat vorgesehen sind.

Eine Verkleinerung der Transistordimensionen in integrierten Bipolartransistorschaltungen leifert nicht nur höhere Packungsdichten, sondern dient auch einer Verbesserung der Schaltgeschwindigkeit. Die Schaltzeit eines vertikalen npn-Transistors wird zu einem wesentlichen Teil von der Basis-Kollektor-Kapazität bestimmt, die bei heutigen Transistorgenerationen von parasitären Bereichen dominiert wird. Diese Bereiche werden sowohl von der Basiskontaktzone (sogenannte inaktive Basiszone) als auch durch Justiertoleranzen bei den verschiedenen Photolacktechniken verursacht. Eine Beseitigung dieser parasitären Zonen würde die Schaltgeschwindigkeit der Transistoren stark erhöhen. Sie gelingt jedoch nur bis zu einem gewissen Grad durch einfaches Verkleinern der Strukturen (sogenanntes "scaling down").

Eine entscheidende Verbesserung bringen die sogenannten Selbstjustierprozesse, wie sie beispielsweise in einem Aufsatz von A. Wieder in den Siemens Forschungs- und Entwicklungsberichten, Band 13 (1984), Nr. 5, auf den Seiten 246 bis 252, beschrieben sind. Bei der insbesondere in Figur 5 dieses Aufsatzes dargestellten Bipolartransistorstruktur ist der Emitter selbstjustiert zu Basis hergestellt.

Aufgabe der Erfindung ist es, ein Verfahren zur Herstellung eines voll selbstjustierten Bipolartransistor mit minimaler Emitterfläche und minimalen parasitären Bereichen anzugeben, bei dem der Basisanschluß so konstruiert ist, daß er möglichst nicht mit der Kollektorzone in Berührung kommt. Insbesondere ist es Aufgabe der Erfindung, ein Verfahren anzugeben, welches mit möglichst wenigen kritischen und maskenaufwendigen Verfahrensschritten auskommt.

Aus dem Stand der Technik sind im wesentlichen zwei Verfahren bekannt, welche die Herstellung selbstjustierter Transistoren mit minimalen parasitären Bereichen beschreiben.

In einem Aufsatz von D. D. Tang et. al. im IEDM Technical Digest 1980, Seiten 58 bis 60, wird ein selbstjustierter symmetrischer Bipolartransistor vorgeschlagen, der besonders für I²L-Schaltkreise geeignet ist. Die aktiven Bereiche dieses Transistors werden dabei durch epitaktische Abscheidungen erzeugt.

Der sogenannte SICOS-Prozeß (= sidewall base contact in silicon), der von T. Nakamura et. al. im IEEE Transaction of Electron Devices, Vol. ED-29 (1982), Nr. 4, auf den Seiten 596 bis 600, beschrieben wird, baut hingegeben auf einer Mesa-Ätzstruktur auf, wobei genau wie bei Tang die aus Polysilizium bestehende Basisanschlußzone auf einer vergrabenen SiO₂-Schicht liegt und die aktive Basis von der Seitenwand kontaktiert wird. Bei beiden Verfahren ist die Basis selbstjustiert zur Isolation.

EP-A 0 029 900 betrifft ein Verfahren zur Herstellung eines selbstjustierten Bipolartransistors, der einen Seitenwandbasiskontakt sowie eine Grabenisolation aufweist, und beschreibt im wesentlichen die Verfahrensschritte a)–k) des Patentanspruchs 1.

Die Erfindung löst die gestellte Aufgabe auf eine andere Weise und ist durch ein Verfahren der eingangs genannten Art durch den Ablauf der im Kennzeichen des Patentanspruches 1 aufgeführten Verfahrensmerkmale gekennzeichnet.

Weitere Ausgestaltungen der Erfindung, insbesondere Verfahren zu seiner Herstellung ergeben sich aus den Unteransprüchen.

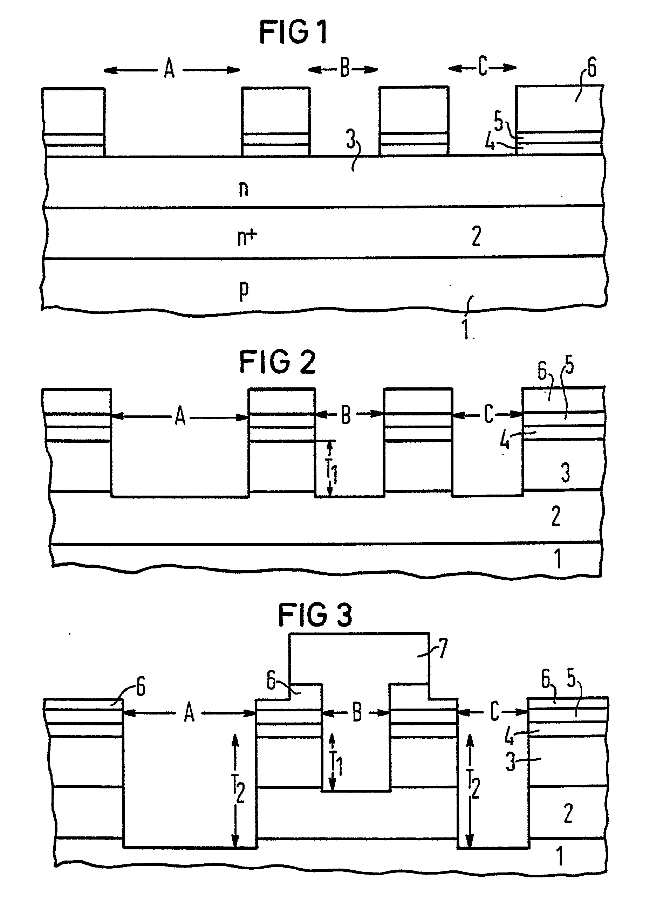

Im folgenden wird anhand eines Ausführungsbeispiels und der Figuren 1 bis 8 die Erfindung, welche die Idee des Seitenwand-Basiskontaktes mit dem Konzept der Grabenisolation in sehr günstiger Weise kombiniert, an einem vertikalen Bipolartransistor vom npn-Typ, noch näher beschrieben. Dabei zeigen die Figuren 1 bis 8 im Schnittbild die erfindungswesentlichen Verfahrensschritte zu seiner Herstellung an, wobei für gleiche Teile gleiche Bezugszeichen gelten.

Figur 1: Die hier abgebildete Anordnung wird durch folgende Verfahrensschritte, welche an und für sich aus dem Stand der Technik bekannt sind (Verfahrensschritte a) bis c), siehe Siemens Forschungs- und Entwicklungsberichte 13 (1984), Seiten 246 bis 252) erzeugt:

a) Bildung des vergrabenen Kollektorbereiches 2 in einem p-dotierten Siliziumsubstrat 1 durch Ionenimplantation von n⁺-dotierenden Ionen (Arsen oder Antimon mit einer Dosis und Energie von $3 \times 10^{15}$ cm⁻² bzw. $2 \times 10^{16}$ cm⁻² und 80 keV),

b) Abscheidung einer n-dotierten Epitaxieschicht 3 ($1$ bis $3 \times 10^{16}$ cm⁻³ As) in einer Schichtdicke von 0,5 bis 2 μm,

c) Erzeugen einer thermisch gewachsenen dünnen Siliziumoxidschicht 4 und Aufwachsen darauf einer durch thermische Zersetzung von Silizium und Sauerstoff enthaltenden Verbindungen von Ammoniak bei niedrigem Druck erzeugten Siliziumnitridschicht 5 (100 nm),

d) Aufbringen einer ersten, zum Beispiel aus Siliziumoxid bestehenden Ätzmaske 6 durch ganzflächige Abscheidung von Siliziumoxid aus thermisch zersetztem Tetraethylorthosilikat und Strukturieren mittels Photolacktechnik so, daß die Bereiche A, C, in denen später die Isolationsgräben erzeugt werden sollen, und den Bereich B, in dem ein Trennungsgraben erzeugt werden soll freigelegt werden,

e) Freiätzen der Bereiche A, B, C mittels bekannter Trockenätzverfahren bis zur Oberfläche der Epitaxieschicht 3.

Durch die Definition der Bereiche A, B, C, ist die Position und Dimension aller elektrisch aktiven Transistorgebiete bereits festgelegt (voll selbstjustierter Transistor).

Figur 2: Es wird nun nach Entfernen der Photolackmaske in den Bereichen A, B, C die Grabenätzung durch die Epitaxieschicht 3 hindurch durchgeführt bis zu einer Grabentiefe $T_1$ so, daß die Epitaxieschicht 3 unterbrochen ist.

Figur 3: Nach der Grabenätzung $T_1$ wird der Grabenbereich B mit einer zweiten Ätzmaske 7, zum Beispiel aus Photolack, deren Fixierung unkritisch ist, abgedeckt und die Gräben A und C bis zu einer Tiefe $T_2$ (ca. 3 - 4 µm) ins Substrat 1 geätzt.

Figur 4: Nach Beendigung der Grabenätzprozesse $T_1$ und $T_2$ wird eine Bor-Ionen-Implantation zur Erzeugung von $p^+$-channel-stopper-Bereichen 8 durchgeführt. Diese Bereiche haben die Funktion, für eine sichere Isolation zwischen benachbarten Kollektorgebieten zu sorgen (Vermeidung eines parasitären Dickoxidtransistors). Dann werden die Photolackmaske 7 und die Reste der Ätzmaske 6 entfernt, alle Gräben A, B und C mittels ca. 50 nm dickem, thermisch gewachsenem Oxid (nicht dargestellt) passiviert und anschließend konform mit Isolationsoxid 9 aufgefüllt.
Die Gräben A, B, C haben alle eine konstante Weite W, so daß das Auffüllen durch Abscheiden einer $SiO_2$-Schicht (9) der Dicke d größer W/2 realisiert werden kann (weil der Basisanschluß seitlich herausgezogen wird, werden in den Schnittbildern von Figur 1 bis 8 unterschiedliche Grabenbreiten vorgetäuscht).
Unter Verwendung einer weiteren unkritischen dritten Photolackmaske (siehe Linie 10) wird nun die Kollektoranschlußzone 11 durch eine Hochenergie-Ionen-Implantation und Diffusion (nicht dargestellt) durch die Schichten 4 und 5 hindurch erzeugt.

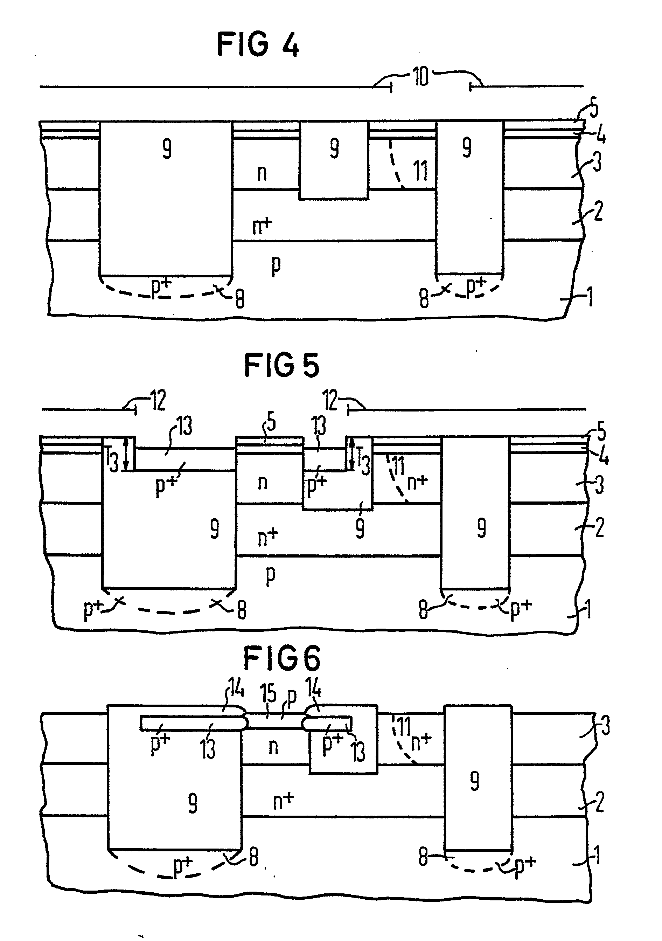

Figur 5: Nun erfolgen die erfindungsgemäßen Selbstjustierschritte, die den Bipolartransistor selbstjustiert zu den Isolationsgräben A und B erzeugen. Dabei wird zunächst nach Entfernung der dritten Photolackmaske 10 zur Herstellung des Basisanschlusses eine vierte Photolackmaske 12 aufgebracht. Mit dieser Photolackmaske 12 und der über dem späteren Emitterbereich liegenden Nitridschicht 5 wird das Oxid (9) teilweise aus den Gräben A und B, die den späteren Emitter umgeben, bis zu einer Tiefe $T_3$ von 0,4 bis 0,5 µm herausgeätzt. Dieses Ringgebiet im Graben (A, B) wird nach Entfernung der vierten unkritischen Photolackmaske 12 mit $p^+$-dotiertem Polysilizium 13 aufgefüllt und durch Rückätzen planarisiert. Dabei sollte durch Überätzen die $p^+$-Polysiliziumoberfläche (13) etwas abgesenkt werden (vergleiche Figur 5), so daß die nun folgende lokale Oxidation (ungefähr 300 nm) einerseits keine zu starken Oberflächenstufen erzeugt, andererseits aber auch genügend tief ins Polysiliziumgebiet 13 hineinreicht (Figur 6).

Figur 6: Das lokal erzeugte Oxid 14 erlaubt im weiteren Prozeßverlauf die Selbstjustierung des Emitters zur Basis. Die Nitridschicht 5 und die Oxidschicht werden entfernt und die aktive Basiszone 15 unmaskiert durch eine Bor-Ionen-Implantation erzeugt.

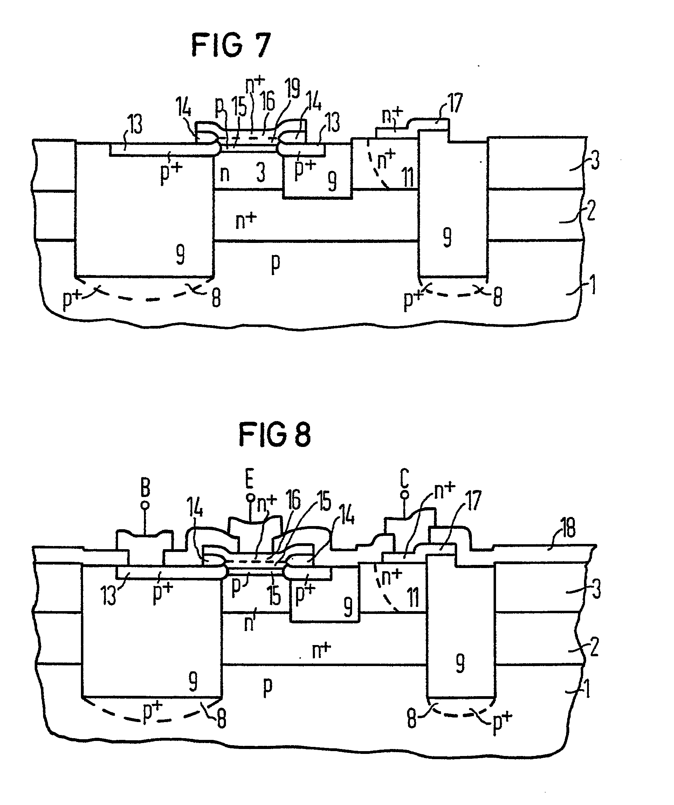

Figur 7: Es folgt eine $n^+$-dotierte Polysilizium-Abscheidung (ca. 100 nm). Diese Schicht wird mit Hilfe einer fünften unkritischen Photolacktechnik (nicht dargestellt) in einem anisotropen Ätzverfahren strukturiert und so die Emitteranschlußzone 16 und der Kollektoranschluß 17 gebildet. Die Emitterzone 19 bildet sich durch spätere Ausdiffusion, selbstjustiert zur Basis.
Nach Entfernung der fünften Photolackmaske wird das freiliegende, lokal erzeugte Oxid anisotrop geätzt unter Benutzung eines Ätzprozesses, der eine hohe Selektivität zu Silizium hat.
Wie aus Figur 7 zu ersehen ist, läßt sich der beschriebene Prozeß hervorragend zur Erzeugung lateraler pnp-Transistoren verwenden: ohne Basis-Implantation und als Streifenstruktur erhält man pnp-Transistoren, die praktisch keine Speicherladung unter den $p^+$-Gebieten akkumulieren können.

Figur 8 zeigt die nach bekannten Verfahrensschritten der Halbleiter-Technologie fertiggestellte erfindungsgemäße Bipolar-Transistorstruktur. Dabei ist die Zwischenisolationsschicht (200 nm) mit dem Bezugzeichen 18 und die Kontakte für Basis, Emitter und Kollektor mit B, E und C bezeichnet.

**Patentansprüche**

1. Verfahren zum Herstellen eines voll selbstjustierten in einer Halbleiterschaltung auf einem Siliziumsubstrat integrierten Bipolartransistors vom npn-Typ mit in vertikaler Richtung im Substrat angeordneten Emitter-, Basis- und Kollektorzonen, bei dem der vergrabene Kollektor durch einen tiefreichenden Anschluß und die aktive Basiszone über eine inaktive Basiszone aus dotiertem polykristallinem Silizium angeschlossen ist und bei dem zur Trennung der Emitter-Basiszone von der Kollektoranschlußzone sowie zur Isolierung des Transistors von benachbarten Bauelementen vergrabene Siliziumoxidbereiche im Substrat vorgesehen sind, **das** folgende Verfahrensschritte in der angegebenen Reihenfolge aufweist:

a) Erzeugen einer $n^+$-dotierten Schicht (2) in einem p-dotierten Siliziumsubstrat (1) durch Ionenimplantation,

b) Aufbringen einer n-dotierten epitaktischen Siliziumschicht (3),

c) Erzeugen einer thermisch gewachsenen Siliziumoxidschicht (4) und Aufwachsen einer, durch thermische Zersetzung erzeugten Siliziumnitridschicht (5),

d) Aufbringen einer als ersten Ätzmaske dienenden Oxidschicht (6) und Strukturieren derselben mittels Photolacktechnik und Trockenätzverfahren in der Weise, daß die Bereiche der die aktiven Zonen des Transistors und der Schaltung trennenden, später zu erzeugenden Isolationsgräben (A, C) und den Bereich des später zu erzeugenden, zwischen aktiver Trasistorzone und Kollektoranschlußbereich liegenden Trennungsgraben (B) freigeätzt werden, Fortsetzung der Trockenätzung durch die Siliziumnitridschicht (5) und die Siliziumoxidschicht (4) und Entfernen der Photolackmaske.

e) Durchführung der Grabenätzung durch die Epitaxieschicht (3) (in einer Tiefe $T_1$) bis zur n+-dotierten Schicht (2) im Substrat (1),

f) Aufbringen einer zweiten als Ätzmaske (7) dienenden Photolackmaske auf die erste Oxidschicht (6) so, daß der zur Trennung der Emitter-Basiszone vom Kollektoranschlußbereich (11) dienende Graben (B) bedeckt wird und Durchätzen der übrigen Gräben (A, C) bis zum p-dotierten Substrat (1) (in zu einer Tiefe von $T_2$),

g) Durchführen einer p-Ionen-Implantation in den Isolationsgräben (A, C) zur Herstellung von p+-Kanalbereichen (8) (sogenannte channel stopper),

h) Entfernen der zweiten und ersten Ätzmaske (7, 6), Erzeugen eines thermischen Oxids in den Gräben (A, B, C) und Auffüllen derselben mit Isolationsoxid (9),

i) Aufbringen einer dritten als Ätzmaske (10) dienenden Photolackmaske so, daß der spätere Kollektoranschluß freibleibt und Implantation des Kollektoranschlußbereiches (11) durch n+-Ionen durch die Siliziumnitrid/Siliziumoxidschicht (5, 4), j) Entfernen der dritten Maske (10) und Aufbringen einer vierten Photolackmaske (12) so, daß der Basisanschlußbereich mit dem später zu erzeugenden Emitter freiliegt,

k) Entfernen der die Gräben (A, B) Auffüllenden obersten, im Basisanschlußbereich liegenden Isolationsoxidschicht (9), wobei die vierte Photolackmaske (12) und die auf dem später zu erzeugenden Emitterbereich (16, 19) befindliche Nitridschicht (5) als Ätzmasken dienen, wodurch ein grabenförmiges Ringgebiet um den zu erzeugenden Emitterbereich entsteht,

l) Entfernen der vierten Ätzmaske (12) und Auffüllen des durch die Oxidschicht-Entfernung entstandenen Ringgebietes mit p+-dotiertem Polysilizium (13),

m) Rückätzen der p+-dotierten Polysilizium-Abscheidung (13) zur Planarisierung der Oberfläche,wobei gezielt im p+-Polysiliziumbereich eine Überätzung bewirkt wird,

n) Durchführung einer lokalen Oxidation unter Verwendung der im späteren Emitterbereich (16, 19) befindlichen Nitridschicht (5) als Oxidationsmaske zur Erzeugung des Isolationsoxids (14) zwischen Basis- und Emitteranschluß, an der Oberfläche des p+-dotierten Polysiliziums (13), o) Erzeugung der aktiven Basiszone (15) durch p-Ionenimplantation nach Entfernung der Nitrid/Oxidschicht (5, 4),

p) Abscheidung einer n+-dotierten Polysiliziumschicht (16, 17) und Strukturierung dieser Schicht mittels einer fünften Ätzmaske so, daß der Emitter- (16) und der Kollektoranschluß (17) gebildet werden,

q) Entfernung der fünften Ätmaske und der nicht von n+-dotiertem Emitteranschlußgebiet bedeckten, lokal erzeugten Oxidschicht durch einen anisotropen, selektiv zu Silizium geführten Ätzprozeß,

r) ganzflächiges Aufbringen einer Zwischenisolationsschicht (18), Kontaktlochätzung und Durchführung der Metallisierung von emitter, Basis und Kollektor in bekannter Weise.

2. Verfahren nach Anspruch 1,**dadurch gekennzeichnet,** daß als erste Ätmaske (6) eine, durch thermische Zersetzung einer Silizium- und Sauerstoff enthaltenden Verbindung erzeugte Siliziumoxidschicht verwendet wird, die mittels Photolacktechnik und anisotropem Ätzverfahren strukturiert wird.

3. Verfahren nach Anspruch 2,**dadurch gekennzeichnet,** daß die Dicke der Siliziumoxidschicht (6) auf ca. 400 nm eingestellt wird.

4. Verfahren nach einem der Ansprüche 1 bis 3,**dadurch gekennzeichnet,** daß die erste Grabenätzung (A, B, C) nach Verfahrensschritt d) bis zu einer Tiefe ($T_1$) von ca. 1 μm geführt wird.

5. Verfahren nach einem der Ansprüche 1 bis 4,**dadurch gekennzeichnet,** daß die oberste Isolationsoxidschicht im Basisanschlußbereich unter Verwendung der Nitridschicht (5) als Ätzmaske nach Verfahrensschritt j) biz zu einer Tiefe ($T_3$) von 0,4 bis 0,5 μm entfernt wird.

6. Verfahren nach einem der Ansprüche 1 bis 5,**dadurch gekennzeichnet,** daß die Dicke der Oxidschicht bei der thermischen Oxidation der Grabenwände (A, B, C) nach Verfahrensschritt h) auf ca. 50 nm eingestellt wird.

**Claims**

1. Method for manufacturing a fully self-adjusted bipolar transistor of the npn type integrated in a semiconductor circuit on a silicon substrate, having emitter zones, base zones and collector zones arranged in a vertical direction in the substrate, in which the buried collector is connected by means of a deeply extending terminal and the active base zone is connected via an inactive base zone consisting of doped polycrystalline silicon and in which buried silicon oxide regions are provided in the substrate for separating the emitter-base zone from the collector terminal zone and for insulating the transistor from adjacent components, said method comprising the following method steps in the given sequence:

a) producing an n+-doped layer (2) in a p-doped silicon substrate (1) by means of ion implantation,

b) applying an n-doped epitaxial silicon layer (3),

c) producing a thermally grown silicon oxide layer (4) and growing over this a silicon nitride layer (5) produced by thermal decomposition,

d) applying an oxide layer sewing as first etching mask (6) and structuring the same by means of photoresist technology and dry etching processes in such a way that the regions of the insulation trenches (A, C) to be produced later which separate the active zones of the transistor and of the circuit and the region of the separation trench (B) to be produced later which lies between active transistor zone and collector terminal region are uncovered by etching, continuing the dry etching through the silicon nitride layer (5) and the silicon oxide layer (4) and removing the photoresist mask.

e) carrying out the etching of the trenches through the epitaxial layer (3) (to a depth $T_1$) as far as the n+-doped layer (2) in the substrate (1),

f) applying a second photoresist mask sewing as etching mask (7) onto the first oxide layer (6), in such a way that the trench (B) sewing for separating the emitter-base zone from the collector terminal region (11) is covered and etching through the other trenches (A, C) as far as the p-doped substrate (1) (to a depth T₂),

g) carrying out a p-ion implantation in the insulation trenches (A, C) to produce p+-channel regions (8) (so-called channel stopper),

h) removing the second and first etching mask (7, 6), producing a thermal oxide in the trenches (A, B, C) and filling the same with insulation oxide (9), i) applying a third photoresist mask sewing as etching mask (10), in such a way that the later collector terminal remains free and implanting the collector terminal region (11) with n+-ions through the silicon nitride/silicon oxide layer (5, 4),

j) removing the third mask (10) and applying a fourth photoresist mask (12), in such a way that the base terminal region, together with the emitter to be produced later, is uncovered,

k) removing the uppermost insulation oxide layer (9) filling the trenches (A, B) and lying in the base terminal region, the fourth photoresist mask (12) and the nitride layer (5) located on the emitter region (16, 19) to be produced later sewing as etching masks, as a result of which a trench-shaped annular area arises around the emitter region to be produced,

l) removing the fourth etching mask (12) and filling the annular area arising through the removal of the oxide layer with p+-doped polysilicon (13),

m) etching back the p+-doped polysilicon deposition (13) to planarize the surface, an overetching being performed selectively in the p+-polysilicon range,

n) carrying out a local oxidation using the nitride layer (5) located in the later emitter region (16, 19) as oxidation mask for producing the insulation oxide (14) between base and emitter terminal on the surface of the p+-doped polysilicon (13),

o) producing the active base zone (15) by p-ion implantation after removing the nitride/oxide layer (5, 4),

p) depositing an n+-doped polysilicon layer (16, 17) and structuring this layer by means of a fifth etching mask, in such a way that the emitter terminal (16) and the collector terminal (17) are formed, q) removing the fifth etching mask and the locally produced oxide layer not covered by the n+-doped emitter terminal region by means of an anisotropic etching process carried out selectively to silicon,

r) applying over the whole surface an intermediate insulation layer (18), etching contact holes and carrying out the metallization of emitter, base and collector in a known manner.

2. Method according to Claim 1, characterized in that a silicon oxide layer produced by thermal decomposition of a compound containing silicon and oxygen is used as first etching mask (6), said silicon oxide layer being structured by means of photoresist technology and an anisotropic etching method.

3. Method according to Claim 2, characterized in that the thickness of the silicon oxide layer (6) is set to approximately 400 nm.

4. Method according to one of Claims 1 to 3, characterized in that the first trench etching (A, B, C) according to method step d) is carried out to a depth (T₁) of approximately 1 μm.

5. Method according to one of Claims 1 to 4, characterized in that the uppermost insulation oxide layer in the base terminal region is removed using the nitride layer (5) as etching mask according to method step j) to a depth (T₃) of 0.4 to 0.5 μm.

6. Method according to one of Claims 1 to 5, characterized in that the thickness of the oxide layer in the case of the thermal oxidation of the trench walls (A, B, C) according to method step h) is set to approximately 50 nm.

**Revendications**

1. Procédé de fabrication d'un transistor bipolaire de type npn, complètement auto-aligné et intégré dans un circuit à semiconducteurs sur un substrat en silicium, et comportant des zones d'émetteur, de base et de collecteurs disposées dans la direction verticale du substrat, et selon lequel on raccorde le collecteur enseveli au moyen d'un raccordement profond, a la zone de base active, par l'intermédiaire d'une zone de base inactive formée de silicium polycristallin dopé, et selon lequel, pour séparer la zone de l'émetteur et de la base vis-à-vis de la zone de raccordement du collecteur et pour isoler le transistor vis-à-vis de composants voisins, on prévoit des zones ensevelies d'oxyde de silicium dans le substrat, ce procédé incluant les étapes opératoires suivantes indiquées dans la suite indiquée:

a) production d'une couche (2) dopée du type n+ dans un substrat en silicium (1) dopé du type p, par implantation ionique,

b) dépôt d'une couche de silicium épitaxiale (3) dopée du type n,

c) production d'une couche d'oxyde de silicium (4), que l'on fait croître par voie thermique, et extension de la couche de nitrure de silicium (5) produite par dissociation thermique,

d) dépôt d'une couche d'oxyde (6) utilisée comme premier masque de corrosion et structuration de cette couche à l'aide d'une technique de laque photosensible et d'un procédé de corrosion à sec de manière à éliminer par décapage les régions des sillons isolants (A, C), qui séparent les zones actives du transistor et du circuit et doivent être produites ultérieurement, la zone du sillon de séparation (B), qui doit être formée ultérieurement et qui est située entre la zone active du transistor et la zone de la bande de raccordement, et poursuite de la correction à sec a travers la couche de nitrure de silicium (5) et à travers la couche d'oxyde de silicium (4) et élimination du masque de laque photosensible,

e) mise en œuvre de la corrosion des sillons a travers la couche épitaxiale (3) (à une profondeur T₁) jusqu'a la couche (2) de type dopé n+ dans le substrat (1),

f) dépôt d'un second masque de laque photosensible utilisé comme second masque de corrosion (7) sur la première couche d'oxyde (6) de manière que le sillon qui sert a séparer la zone de base de l'émetteur de la zone de raccordement (B) du collecteur (11), soit recouverte et la corrosion des autres sillons (A, C) jusqu'au substrat (1) de type dopé p (à une profondeur T2),

g) mise en œuvre d'une implantation d'ions du type p dans les sillons isolants (A, C) pour la fabrication de zones de canal de type p+ (8) (ce qu'on appelle des channel stopper, c'est-à-dire des dispositifs d'arrêt de canal),

h) élimination du second et du premier masques de corrosion (7, 6), production d'un oxyde thermique dans les sillons (A, B, C) et remplissage de ces sillons avec un oxyde isolant (9),

i) dépôt d'un troisième masque de laque photosensible utilisé comme masque de corrosion (10), de sorte que la borne de collecteur, formée ultérieurement, subsiste, et implantation de la zone de borne de collecteur (11) au moyen d'ions n+ à travers la couche de nitrure de silicium/oxyde de silicium (5, 4),

j) élimination du troisième masque (10) et dépôt d'un quatrième masque photosensible (12) de sorte que la zone de borne de base munie de l'émetteur devant être formée ultérieurement est à nu,

k) élimination de la couche supérieure d'oxyde isolant (9), qui remplit les sillons (A, B) et située dans la zone de la borne de base, le quatrième masque de laque photosensible (12) et la couche de nitrure (5) située sur la zone d'émetteur (16, 19) devant être formée ultérieurement, devant être utilisés en tant que masque de corrosion, ce qui va d'abord être une structure annulaire en forme de sillons isolée autour de la zone d'émetteur devant être produite,

l) élimination du quatrième masque de corrosion (12) et remplissage de la zone annulaire, apparue sous l'effet du retrait de la couche d'oxyde, au moyen de polysilicium (13) dopé du type p+,

m) rétrocorrosion du dépôt de silicium dopé du type p+ pour rendre plane la surface, auquel cas on exécute volontairement une corrosion excessive dans la zone de silicium de type p+,

n) mise en œuvre d'une oxydation locale moyennant l'utilisation de la couche de nitrure (5) située dans la zone d'émetteur (16, 19), formée ultérieurement, en tant que masque d'oxydation pour produire l'oxyde isolant (14) entre la borne de base et la borne d'émetteur, sur la surface du polysilicium (13) dopé du type p+,

o) production de la zone de base active (15) par implantation d'ions de type p après élimination de la couche de nitrure/d'oxyde (5, 4),

p) dépôt d'une couche de polysilicium (16, 17) dopée du type n+ et structuration de cette couche a l'aide d'un cinquième masque de corrosion de manière a former la bande d'émetteur (16) et la borne de collecteur (17),

q) élimination du cinquième masque de corrosion et de la couche d'oxyde produite localement, non recouverte par la zone de raccordement d'émetteur dopée de type n+, tu moyen d'un procédé de corrosion d'un isotrope, exécutée de manière sélective vis-à-vis du silicium,

r) dépôt, sur toute la surface, d'une couche isolante intercalaire (18), aménagement par corrosion des trous de contact et insertion, d'une manière connue, de la métallisation pour l'émetteur, la base et le collecteur.

2. Procédé suivant la revendication 1, caractérisé par le fait qu'on utilise, comme premier masque de corrosion (6), une couche d'oxyde de silicium, qui est produite par dissociation thermique d'un composé contenant du silicium et de l'oxygène et que l'on structure a l'aide d'une technique utilisant une laque photosensible et d'un procédé de corrosion anisotrope.

3. Procédé suivant la revendication 2, caractérisé par le fait qu'on règle l'épaisseur de la couche d'oxyde de silicium (6) à environ 400 nm.

4. Procédé suivant l'une des revendications 1 à 3, caractérisé par le fait qu'on réalise la première corrosion (A, B, C) de formation des sillons conformément à l'étape opératoire d) jusqu'à une profondeur (T1) égale a environ 1 µm.

5. Procédé suivant l'une des revendications 1 à 4, caractérisé par le fait qu'on élimine la couche supérieure d'oxyde isolant au niveau de la borne de base, en utilisant la couche de nitrure de silicium (5) comme masque conformément à l'étape opératoire j) jusqu'à une profondeur (T3) comprise entre 0,4 et 0,5 µm.

6. Procédé suivant l'une des revendications 1 à 5, caractérisé par le fait qu'on règle l'épaisseur de la couche d'oxyde, lors de l'excitation thermique des parois des sillons (A, B, C) lors de l'état préparatoire h), à environ 50 nm.

# FIG 1

# FIG 2

# FIG 3

# FIG 4

# FIG 5

# FIG 6

# FIG 7

# FIG 8